# EUROPEAN PATENT APPLICATION

(11) **EP 2 472 420 A1**
(43) Date of publication of application: **04.07.2012**
(21) Application number: 10197105.9
(22) Date of filing: 28.12.2010
(51) Int. Cl.: G06F 17/50

(54) **Method of recognition and insert of the logical schemes**

(71) Applicant: POLYTEDA Software Corporation Limited, 3105 Limassol (CY)
(72) Inventor: Marchuk, Volodymyr, Toronto Ontario M6S1Z3 (CA); Moliavko, Oleksandr, 03127 Kyiv (UA)
(74) Representative: Benatov, Emil Gabriel

(57) **Abstract**

The method is used in design of the integrated circuits, and performs the following operations on the figure. The approximate sequence of operations of method of recognition and insertion of the logical circuits in algorithmic form. The advantage of the created method is in the increased performance and reduced resource consumption.

## Description

### FIELD OF THE INVENTION

Method of recognition and insertion of the logical schemes is used in design of the integrated circuits.

### BACKGROUND OF THE INVENTION

During the design of the integrated circuits (IC) it is very important to recreate accurately the logical structure in the layout of IC. To check the correctness of implementation before manufacturing the IC it is important to extract the schematic from the layout and compare the extracted schematic with the one given by the designer.

The modem ICs usually consist of millions and billions of components, organized into the logical gates, registers and other structures. The comparison of the initial schematic with the one extracted from layout is very time consuming, if it is possible at all. To simplify the task, the schematic extracted from layout is divided into hierarchical subcircuits. For instance, a few transistors create one logical element, a few logical elements create a register and so on. Such hierarchical representation makes the comparison of extracted schematic with initial one much simpler.

There are many different methods of building a hierarchy of subcircuits - for example, the text marks in the layout, or the heuristic algorithms.

There is a known method of recognition and insertion of the logical circuits [US7716611]. It is used to recognize the logical circuits in the netlists and to replace the instances of these circuits in the netlists with equivalent insertion objects. For every instance of recignized logic circuit various parameters of devices comprising this circuit can be taken into account and stored in a replacing insertion object. Moreover, during the identification of logical circuits the parameters of comprising devices can be taken into account - e.g., the length and width. The method performs the following:

Searches in the netlist describing the extracted schematic for all the instances of the required logical circuit (logical circuit consists of many devices).

For every found instance of the required logical scheme it creates the equivalent insertion object and replaces with this object the found instance of logical circuit.

Drawback of the given method of recognition and insertion of logical circuits is its low performance and high resource consumption. This is caused by repeated searching of netlists containing large amounts of devices, of which very few actually compose the sought logical circuits.

### SUMMARY OF THE INVENTION

The objective of the invention was to create a method of recognition and insertion of the logical circuits with increased performance and reduced resource consumption.

This objective can be achieved using the method of the recognition and insert of the logical schemes, where in the beginning 1 a module of definition of the logical circuits receives the descriptions of logical circuits, 2 the list of devices that comprise the analyzed circuit is loaded, and 3 logical circuit recognition module gets the description of the logical circuits. Also, when required - sequentially the following is performed: 13 the module responsible for generation of the insertion objects creates one insertion object for each instance of the found logical circuit 14 and replaces those instances with insertion objects. Separately 15 the modified analyzed circuit is shown. After the 3 logical circuits recognition module receives the description of the logical circuits - the following is sequentially performed: 4 the selection of the description of the logical circuit to recognize, 5 selection of the initial device among the devices from the netlist that were not analyzed yet, 6 the selection of devices located near initial device, 7 recognition of selected logical circuit among selected devices. After that 8 method checks if the required logical circuit is found. If not, 9 it is checked whether all the selected devices were analyzed and if in the check 8 - yes, then 13 the module responsible for generation of the insertion objects creates one insertion object for each instance of the found logical circuit and 14 replaces those instances with insertion objects. After that 9 method checks whether all selected devices were analyzed, if yes - 10 all the selected devices are marked as "analyzed", if no - the cycle is performed again starting with 7 recognition of selected logical circuit among selected devices. After 10 all the selected devices are marked as "analyzed" - there is 11 a check whether the netlist contains some devices that were not analyzed yes. If there are some devices not analyzed yet - again, the cycle is repeated starting from 5 selection of the initial device among the devices from the netlist that were not analyzed yet, and if not - 12 method checks if all the recognition of all the required logical circuits was performed, if no - the cycle is repeated starting 4 the selection of the description of the logical circuit to recognize, if yes - 15 modified analyzed circuit is shown, after that - the work of the method of recognition and insertion of the logical circuits is over.

The advantage of the created method is in the increased performance and reduced resource consumption.

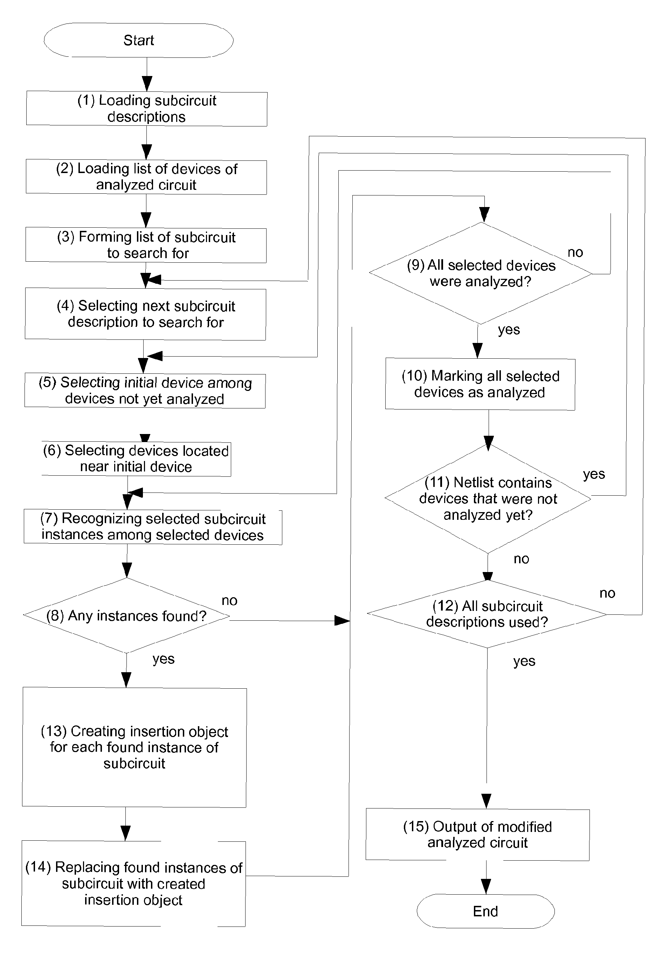

### BRIEF DESCRIPTION OF THE DRAWING

The flow figure shows the approximate sequence of operations of method of recognition and insertion of the logical circuits in algorithmic form.

### DETAILED DESCRIPTION OF A PREFERENTIAL EMBODIMENT

The method of the recognition and insert of the logical schemes performs the following operations:
1. The definitions of the logical circuits which must be recognized in analyzed netlist are loaded;
2. The list of devices of the analyzed circuit is loaded;
3. Logical circuit recognition module gets the description of the logical circuits which need to be recognized in analyzed circuit;
4. The next description is chosen from the list of the descriptions of the logical circuits which need to be recognized in analyzed circuit (in the beginning of the algorithm's work the first description is chosen, then the rest of descriptions are used by-turn);
5. From the list of devices that comprise the analyzed circuit, a device not analyzed yet is selected (in the beginning of the algorithm's work all the devices are not analyzed yet). The chosen device must be of the type used in the recognized logical circuit;
6. Form the list of devices algorithm selects devices located near one selected in 5.
7. Among the devices selected in 6 algorithm recognizes the groups that comprise the instances of sought logical circuit.
8. If the instance of the sought logical circuit is found, 13 and 14 are performed sequentially, otherwise - 9 is performed.
9. Algorithm checks if all the devices selected in 6 are analyzed. If no - the cycle is performed again starting the 7, otherwise it is started from 10.
10. All the devices selected in 6 are marked as "analyzed".
11. It is checked, whether the analyzed circuit has some devices not yet analyzed left. If yes - the cycle starts again from the 5, otherwise 12 is performed.
12. Algorithm checks if all the descriptions of the recognized logical circuits have been used for the recognition. If yes - 15 is performed, if no - the cycle starts again from the 4.
13. The insertion object is created that will describe the instance of the recognized logical circuit.
14. The insertion object created in 13 is inserted into the analyzed circuit, replacing the group of devices that compromise the instance of recognized logical circuit.
15. The output of the changed logical scheme is performed.

## Claims

1. The method of the recognition and insertion of the logical circuit in which following operations are sequentially performed: (1) a module of definition of the logical circuits receives the descriptions of logical circuits, (2) the list of devices that comprise the analyzed circuit is loaded, and (3) logical circuit recognition module gets the description of the logical circuits. Also, when required - sequentially the following is performed: (13) the module responsible for generation of the insertion objects creates one insertion object for each instance of the found logical circuit (14) and replaces those instances with insertion objects, and separately (15) the modified analyzed circuit is shown, with the following difference: after the (3) logical circuit recognition module gets the description of the logical circuits, the following is performed sequentially: the selection of the description of the logical circuit to recognize, (5) selection of the initial device among the devices from the netlist that were not analyzed yet, (6) the selection of devices located near initial device, (7) recognition of selected logical circuit among selected devices. After that (8) method checks if the required logical circuit is found. If not, (9) it is checked whether all the selected devices were analyzed and if in the check (8) - yes, then (13) the module responsible for generation of the insertion objects creates one insertion object for each instance of the found logical circuit and (14) replaces those instances with insertion objects. After that (9) method checks whether all selected devices were analyzed, if yes - (10) all the selected devices are marked as "analyzed", if no - the cycle is performed again starting with (7) recognition of selected logical circuit among selected devices. After (10) all the selected devices are marked as "analyzed" - there is (11) a check whether the netlist contains some devices that were not analyzed yes. If there are some devices not analyzed yet - again, the cycle is repeated starting from (5) selection of the initial device among the devices from the netlist that were not analyzed yet, and if not - (12) method checks if all the recognition of all the required logical circuits was performed, if no - the cycle is repeated starting (4) the selection of the description of the logical circuit to recognize, if yes - (15) modified analyzed circuit is shown, after that - the work of the method of recognition and insertion of the logical circuits is over.
